(19) Europäisches Patentamt

European Patent Office

Office européen des brevets

(11) **EP 1 322 114 B1**

(12) **EUROPEAN PATENT SPECIFICATION**

(45) Date of publication and mention
of the grant of the patent:
**22.02.2006 Bulletin 2006/08**

(51) Int Cl.:
*H04N 7/00* (2006.01)    *H04N 7/01* (2006.01)
*H03H 17/02* (2006.01)

(21) Application number: **02258037.7**

(22) Date of filing: **21.11.2002**

(54) **Method and apparatus for vertical compression and decompression of progressive video data**

Verfahren und Vorrichtung zur vertikalen Datenkompression und -Dekompression von progressiven Videosequenzen

Procédé et dispositif pour la compression et la décompression verticale de séquences vidéo progressives

(84) Designated Contracting States:
**DE FR GB**

(30) Priority: **21.11.2001 US 332045 P**

(43) Date of publication of application:
**25.06.2003 Bulletin 2003/26**

(73) Proprietor: **Broadcom Corporation**
**Irvine, CA 92618 (US)**

(72) Inventors:
• **Macinnis, Alexander G.**
**Los Altos,**
**California 94022-1017 (US)**
• **Zhong, Sheng**
**Fremont,**
**California 94538 (US)**
• **Alvarez, Jose R.**
**Sunnyvale,**
**California 94087 (US)**

(74) Representative: **Jehle, Volker Armin et al**
**Patentanwälte**
**Bosch, Graf von Stosch, Jehle,**
**Flüggenstrasse 13**
**80639 München (DE)**

(56) References cited:
EP-A- 0 327 268      EP-A- 0 562 851
WO-A-01/52546      US-A- 5 892 695
US-A1- 2001 017 631

**Description**

BACKGROUND OF THE INVENTION

Television (TV) content distribution is quickly migrating from analog formats to compressed digital formats. TV content is distributed digitally today via satellite, cable, terrestrial (RF), DSL, DVD, Internet, and other transmission and storage means. It is a well known problem to minimize the bit rate of the compressed signal while maximizing the final video quality. Various companies and standards bodies are fiercely competing to provide methods to minimize the compressed bit rate while providing acceptable video quality. Such competition continues to be very active, even though the MPEG-2 video standard (ISO/IEC 13818-2) has been final for several years and many millions of TV receivers are in use today that implement the MPEG-2 standard. A technology solution that can reduce the compressed bit rate by even a few percent without hurting the final picture quality can gain a significant advantage over existing technologies.

Video content distributed for TVs can be segmented into two classes: progressive content and interlaced content. All conventional TVs implement interlaced displays. Progressive content is also common in the TV world, particularly movies. Almost all movies are shot on film, with a few being computer generated, and film and computer generated content types are inherently progressive in their scanning structure. Other content besides movies also may use film or computer generation, and retain the progressive scanning structure.

Currently nearly all digital video content, whether progressive or not, that is distributed for TV display, is compressed using MPEG-2 video (ISO/IEC 13818-2) or in some cases MPEG-1 (ISE/IEC 11172-2). All digital video content for TVs, as far as we know, is compressed with a picture format that includes a picture height that matches the height of the active video display of the TV, i.e., 480 lines for NTSC TVs or 576 lines for PAL and SECAM TVs, or in some cases of lower quality systems, the coded picture height matches half the height of the TV, i.e. 240 lines for NTSC or 288 lines for PAL & SECAM. When progressive content is decoded and displayed on an interlaced TV, the content must be converted from progressive to interlaced content. In conventional systems, such conversion consists of one set of even or odd lines, e.g., even, of each de-compressed progressive picture on one interlaced field, e.g., top field, and the other set of lines, e.g., odd on the other, e.g., bottom interlaced field. In addition, a method called "3:2 pulldown" is commonly used to convert the approximately 24 frame per second timing of film content to the approximately 60 field per second timing of NTSC displays.

Further limitations and disadvantages of conventional and traditional approaches will become apparent to one of skill in the art, through comparison of such systems with the present invention as set forth in the remainder of the present application with reference to the drawings.

BRIEF SUMMARY OF THE INVENTION

Certain embodiments of the present invention provide vertical compression and de-compression of progressive video data using polyphase filtering. The size of the vertical video data is reduced by polyphase filtering the vertical video data to perform down-sample rate conversion and low pass filtering of the vertical video data. The size of the vertical video data is then increased by polyphase filtering the vertical video data to perform up-sample rate conversion of the vertical video data. Horizontal video size may also be scaled and descaled in accordance with certain embodiments of the present invention. In addition, standard video compression and de-compression techniques such as MPEG-1, MPEG-2, MPEG-4, or MPEG-AVC may be used in accordance with certain embodiments of the present invention.

A method is provided for vertical compression and de-compression of progressive video data using polyphase filters. Included in the vertical compression method is the step of polyphase filtering a first number of lines of video data to generate a second number of lines of video data. Included in the vertical de-compression of video data is the step of polyphase filtering the second number of lines to re-create the original first number of lines of video data. In an embodiment of the present invention, the first number of lines comprises 480, and the second number of lines comprises 320. Polyphase filtering to reduce the vertical video data size includes the aspects of low-pass filtering with a cutoff frequency of about 0.67 of a vertical Nyquist sample rate of the vertical video data and sample rate converting the vertical video data to a lesser number of samples. In an embodiment of the present invention, the vertical reduction of video data size may be realized using two phases of finite-impulse-response filters with twelve taps per phase to accomplish polyphase filtering. Polyphase filtering to increase the vertical video data size includes the aspect of sample rate converting the vertical video data up to the original number of samples. In an embodiment of the present invention, the polyphase filtering to increase the vertical video data size may be realized using three phases of finite-impulse-response filters with eight taps per phase. The method includes scaling and de-scaling of the number of horizontal pixels of video data. The method includes employing one of a number of standard techniques of video compression and de-compression, such as MPEG-1, MPEG-2, MPEG-4, and MPEG-AVC.

An apparatus is provided for vertical compression and de-compression of progressive video using polyphase filters. The apparatus includes a vertical video data processor that polyphase filters a first number of vertical lines of video data to generate a second number of vertical lines of video data. In an embodiment of the present invention, the vertical video data processor's polyphase filter applies a low-pass filter with a cutoff frequency of about 0.67 of a vertical Nyquist sample rate of the video data. In an embodiment of the present invention, the vertical video data processor's polyphase filter sample rate converts the vertical lines of video data to a lesser number of vertical lines. The apparatus also includes a vertical video data re-processor that polyphase filters the second number of vertical lines to re-create the first number of vertical lines of video data. In an embodiment of the present invention, the vertical video data re-processor's polyphase filter sample rate converts the vertical lines of video data to the original number of vertical lines. In an embodiment of the present invention, the first number of vertical lines of video data comprises 480, and the second number of vertical lines of video data comprises 320. In the present invention, the polyphase filter in the vertical video data processor comprises two phases of finite-impulse-response filters with twelve taps per phase, and, the polyphase filter in the vertical video data re-processor comprises three phases of finite-impulse-response filters with eight taps per phase. In an embodiment of the present invention, the apparatus includes a horizontal video data scaler and a horizontal video data de-scaler. In an embodiment of the present invention, the apparatus includes a video data compressor and a video data de-compressor that implement one of a number of standard video compression and de-compression techniques, such as MPEG-1, MPEG-2, MPEG-4, and MPEG-AVC.

These and other advantages and novel features of the present invention, as well as details of an illustrated embodiment thereof, will be more fully understood from the following description and drawings.

BRIEF DESCRIPTION OF THE DRAWINGS

Fig. 1 is a flowchart of a method for vertical compression and de-compression of progressive video data using polyphase filtering to perform low-pass filtering and sample rate conversion in accordance with an embodiment of the present invention.

Fig. 2 is a schematic block diagram of an apparatus for compressing and de-compressing video data comprising polyphase filters in accordance with an embodiment of the present invention.

Fig. 3 is a schematic block diagram of a two phase polyphase filter that performs vertical video data processing in accordance with an embodiment of the present invention.

Fig. 4 is a schematic block diagram of a three phase polyphase filter that performs vertical video data re-processing in accordance with an embodiment of the present invention.

DETAILED DESCRIPTION OF THE INVENTION

Progressive content is processed before compression to remove approximately 1/3 of the picture area with no loss of perceptual quality when displayed on interlaced devices. The resulting reduced size image is compressed, transmitted or stored, de-compressed, reprocessed to suit the display, and displayed. One embodiment of the present invention comprises vertical low pass filtering combined with sample rate conversion to a lower vertical sample rate, preferably 2/3 of the original vertical sample rate, before compression. After de-compression, the resulting pictures are sample rate converted up to the desired vertical display height and displayed.

Aspects of the present invention are based on a principle of perception known as the Kell factor. The Kell factor indicates that the maximum vertical resolution humans may perceive on an interlaced display is less than the resolution that would be provided by a progressive display of the same height (measured in units of scan lines), and more than the resolution that would be provided by a progressive display of the height of an individual field, which is half the total height of the display. The resulting ratio of effective vertical resolution of interlaced displays to the maximum vertical resolution of progressive displays of the same number of lines is generally considered to be between 0.6 and 0.7. In one embodiment of the present invention, a factor of 0.67 is used. Of course, smaller or larger factors may also be used.

Progressive video content is filtered and scaled (i.e. sample rate converted) vertically to a smaller size (picture height) than the original, such that the final display quality is retained while the size of the pictures to be compressed is reduced substantially.

Aspects of the present invention are described here procedurally, using some examples. In the following examples, we assume a system intended for NTSC-compatible display with 480 lines per frame and approximately 30 (actually 29.97) frames per second, which is approximately 60 (actually 59.94) fields per second. Without loss of generality, the principles of the present invention apply to systems with different picture heights and frame rates, while some details of the implementation may differ.

Movie (typically film) content to be compressed is conventionally provided to the compression system scanned to a picture height of 480 lines. The horizontal resolution may be chosen independently and typically ranges from 352 to 720; however any horizontal resolution may be chosen in connection with the present invention and various embodiments, as it is common to use a variety of horizontal sample rates. In conventional compression systems for TV broadcast or storage, the 480 line picture height is retained through the processes of compression, transmission or storage, de-compression and display, even though the horizontal picture size may be reduced from the maximum of 720 pixels set, of the ITU-R Bt.601 recommendation, to a smaller number before compression, and converted back after de-compression.

With 480 lines per frame, the maximum vertical frequency that may be represented such that the frame may be reconstructed and perceived correctly is limited to 240 cycles/picture height, as established by the theory of Nyquist. A 480 line frame height has 240 lines per field in an interlaced system. Considering a single field as an image, it has a Nyquist limit of 120 cycles per picture height. Note that the height of a single field is essentially the same as the height of a full frame. The 240 cycles per picture height maximum is referred to here as the Nyquist limit, or Nyquist for short, where it is clear from context. That is, "1.0 Nyquist" in the following refers to 240 cycles per picture height for a display with 480 scan lines per frame.

Experiments, consistent with the Kell factor theory, show that vertical signal bandwidth up to a maximum of approximately 0.67 Nyquist is the maximum that is perceivable as vertical resolution by a human when the display is an interlaced TV. The exact number is somewhat subjective, and may be considered to be between 0.6 and 0.7. In any case, it is generally greater than 0.5, and less than 1.0. Note that a vertical frequency of 0.5 Nyquist for frames of display is the same vertical frequency as 1.0 Nyquist for a single field of the same display format, since a field has half as many lines as a frame. At higher frequencies than 0.67 (or 0.7) Nyquist, the appearance is that of flickering more than of lines of resolution. Images with vertical bandwidth content of more than approximately 0.67 Nyquist look better after vertical low pass filtering to a bandwidth of approximately 0.67 Nyquist, with no visual loss of resolution, because the flickering is reduced. Film content that is intended for display on TVs is typically low pass filtered vertically in a similar manner. Images that do not have vertical bandwidth above approximately 0.67 Nyquist are not altered in a meaningful way by vertical low pass filtering with a cutoff frequency of approximately 0.67 Nyquist.

In accordance with an embodiment of the present invention, it is possible not only to low pass filter the content vertically before compression, but also to sample rate convert the content to a reduced number of lines, e.g., 0.67 times the original number of lines, compress the video, transmit or store it, de-compress it, convert it for display, and display it, with no loss of visually perceptible quality when compared with the conventional method of compressing and de-compressing the entire picture height of e.g. 480 lines. A sample rate converter, whose embodiment is in the form of a polyphase filter, is used in connection with this aspect of the present invention. In addition, the sample rate converter is followed by another sample rate converter that performs the inverse sample rate conversion, resulting in faithful representation of the signal within the passband. Polyphase filters have been designed and tested in accordance with an embodiment of the present invention to perform such filtering and conversion, and it has been demonstrated that there is no visual loss of quality resulting from such sample rate conversion, at least when implemented with high quality conversions.

In one embodiment of the present invention, 480 lines of picture height are converted to 320 lines of picture height, a ratio of 0.67, before compression, and converted back after de-compression. The 320 lines of picture height have only 2/3 as many lines to compress as 480 lines of picture height, and for any given consistent picture width, there are only 2/3 as many pixels to compress. The gains in compression may not be as high as savings of 1/3 of the bits (consistent with saving 1/3 of the pixels), but savings are substantial, typically in the range of 20 - 33%.

Such conversions have been integrated with a video compression, storage, and de-compression system, and demonstrated that performance is consistent with the theory. There is no apparent visual loss of vertical resolution due to the vertical conversion, and there is a substantial savings of bits compared to a full height image of the same width.

Equivalently, the horizontal size of video before compression may be increased for improved image quality, while the vertical size is decreased in accordance with an embodiment of the present invention, while keeping the overall number of pixels similar, or slightly smaller or greater than would have been the case in conventional systems, for improved picture quality at approximately the same bit rate. For example, a typical conventional low bit rate compression of film content compresses a picture size of 352 x 480, commonly known as "HHR" for half horizontal resolution. By implementing the present invention, the vertical height may be reduced to 320 lines before compression, and the original 720 pixel content may be scaled to 512 pixels, with the result that the overall picture size of 512 x 320 = 163,840 pixels per frame is actually less than the conventional picture size of 352 x 480 = 168,960 pixels per frame. For the same settings of independent parameters with a state of the art video compression algorithm, the compressed bit rate is somewhat lower using the present invention, while the picture quality is significantly improved through increases in horizontal resolution, while there is no loss of perceivable vertical resolution.

There are a number of video compression and de-compression systems, not including the present invention, that are known and may be used in connection with the present invention. Examples include the publicly available reference software for compression and de-compression of various standards and standards under development, including MPEG-1 (ISO/IEC 11172-2), MPEG-2 (ISO/IEC 13818-2), MPEG-4 (ISO/IEC 14496-2), and MPEG-AVC (ISO/IEC 14496-10).

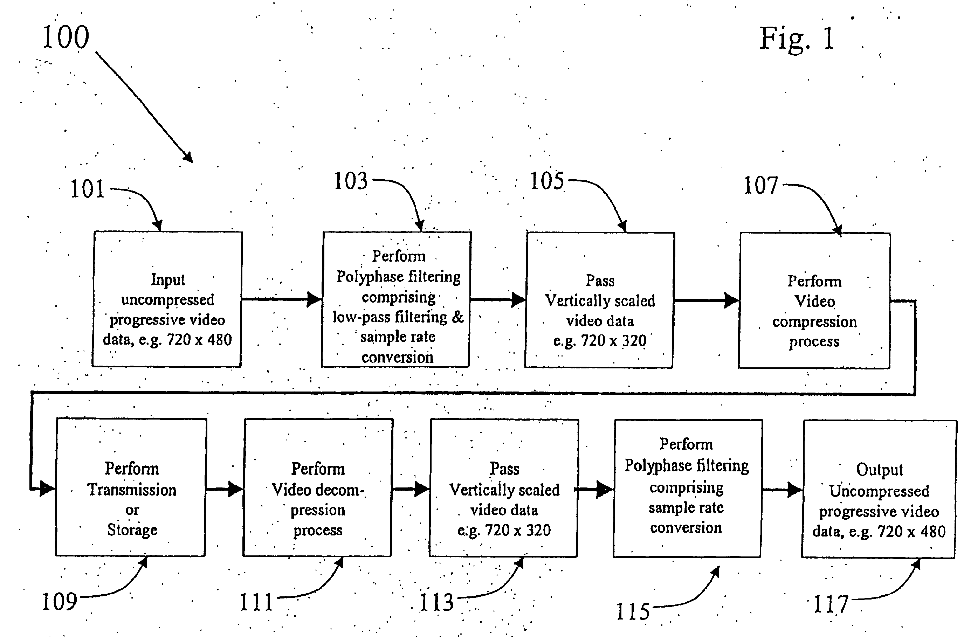

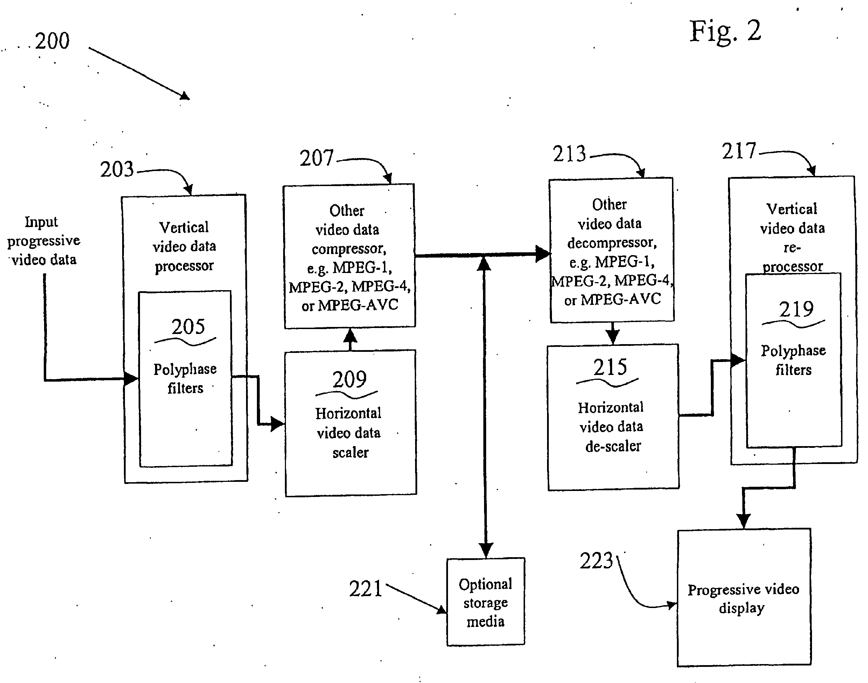

Figures 1 and 2 show data flow and block diagrams respectively for one embodiment of a system comprising vertical compression, as discussed above, in accordance with an embodiment of the present invention. The method 100 takes an input stream of video content having a picture size of, for example, 720 X 480 pixels per frame in step 101. The video content is then low-pass filtered and sample rate converted in step 103, as discussed above, to reduce the vertical picture height to 320 lines. The low-pass filtering and sample rate conversion is accomplished by means of a vertical video data processor 203 comprising a polyphase filter 205. In the example, the resulting vertically scaled video now has a pixel size of 720 X 320 pixels per frame. The vertically scaled video may be passed on for video compression in step 107, as discussed above, to even further reduce the overall picture size. The compression process may be achieved by means of a horizontal video data scaler 209 and a video data compressor 207 implementing a standard compression technique such as MPEG-1, MPEG-2, MPEG-4, and MPEG-AVC. The video is then transmitted or stored in step 109 in, for example, storage media 221.

When the video is received (i.e. either directly or from storage, as the case may be), the video is de-compressed in step 111 using a de-compression process that corresponds to the compression process performed in step 107. The de-compression process may be achieved by means of an additional horizontal video data de-scaler 215 and a video data de-compressor 213 implementing a standard de-compression technique such as MPEG-1, MPEG-2, MPEG-4, and MPEG-AVC. In the example, the resulting video now has a pixel size of 720 X 320 pixels per frame, corresponding to the vertically scaled video data in step 105. The video is passed in step 113 to vertical video re-processor 217. The video data is then polyphase filtered in step 215 resulting in sample rate conversion of the video. The sample rate conversion is accomplished by means of an additional vertical video data re-processor 217 comprising a polyphase filter 219. In the example, the resulting de-compressed video is output at 720 X 480 pixels per frame in step 117 and may then be transmitted to a progressive video display 223.

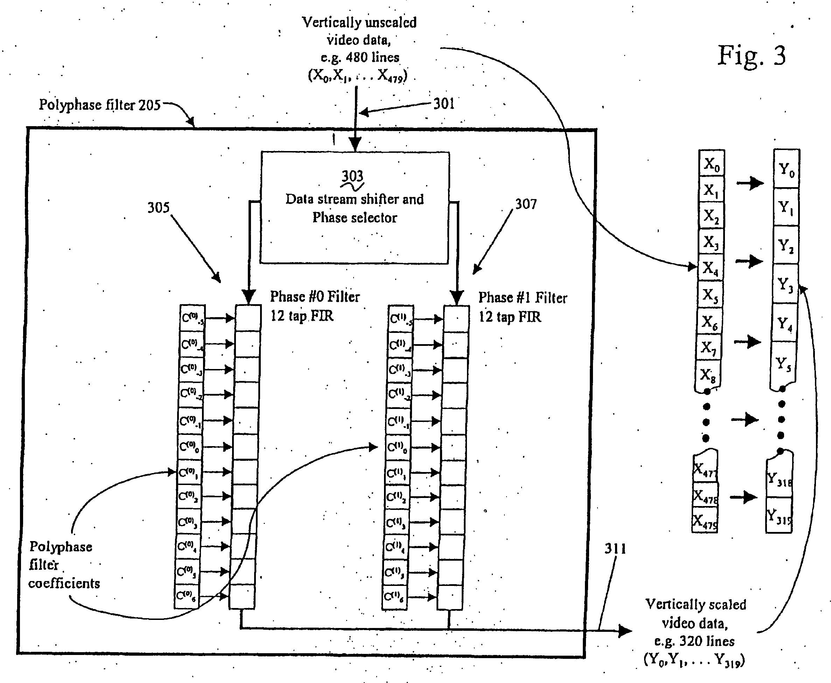

Fig. 3 is a block diagram detailing the structure of the polyphase filter 205 implemented in the vertical video data processor 203, in accordance with an embodiment of the present invention. The polyphase filter 205 reduces the number of lines, e.g. 480, of the input video data stream 301 to a lesser number of lines, e.g. 320, in the scaled output video data stream 311. The data stream shifter and phase selector 303 controls both the phase paths 305 and 307, and the input data center used to generate an output data point. For each output $Y_n$ (n = 0, 1, 2, ...) the phase index P for the polyphase filter is derived by:

P = 3n % 2, where % means divide and take the remainder.

For each output $Y_n$ (n = 0, 1, 2, ...) the input data center $X_m$ is selected for filtering. For the twelve tap FIR filters corresponding to the two phase paths 305 and 307 in the example, the input data center is the 6th tap on the filters. For each output $Y_n$ (n = 0, 1, 2, .. .) the input data center $X_m$ is derived by:

m = [3n/2], where [ ] means the integer part.

Therefore the following correspondences are achieved in vertical video data processing:

| Output pixels: | $Y_0$ | $Y_1$ | $Y_2$ | $Y_3$ | $Y_4$ | $Y_5$ | $Y_6$ | $Y_7$ | ... |
|---|---|---|---|---|---|---|---|---|---|
| Filter center pixels (input): | $X_0$ | $X_1$ | $X_3$ | $X_4$ | $X_6$ | $X_7$ | $X_9$ | $X_{10}$ | ... |
| Phase: | 0 | 1 | 0 | 1 | 0 | 1 | 0 | 1 | ... |

To further illustrate the current example, output pixel $Y_5$ is generated by the Phase #1 filter path 307 according to the following formula:

$$Y_5 = \sum_{i=-5}^{6} C_i^{(1)} \bullet X_{7+i}$$

Where the values of coefficients of the phase #1 filter path 307 are:

$C_6^{(1)}$  -1/256

$C_5^{(1)}$  -1/256

$C_4^{(1)}$  8/256

$C_3^{(1)}$  -14/256

$C_2^{(1)}$  -7/256

$C_1^{(1)}$  143/256

$C_0^{(1)}$  143/256

$C_{-1}^{(1)}$  -7/256

$C_{-2}^{(1)}$  -14/256

$C_{-3}^{(1)}$  8/256

$C_{-4}^{(1)}$  -1/256

$C_{-5}^{(1)}$  -1/256

Similarly, output pixel $Y_6$ is generated by the Phase #0 filter path 305 according to the following formula:

$$Y_6 = \sum_{i=-5}^{6} C_i^{(0)} \bullet X_{9+i}$$

Where the values of coefficients of the phase #0 filter path 305 are:

| $C_{-5}^{(0)}$ | $C_{-4}^{(0)}$ | $C_{-3}^{(0)}$ | $C_{-2}^{(0)}$ | $C_{-1}^{(0)}$ | $C_{0}^{(0)}$ | $C_{1}^{(0)}$ | $C_{2}^{(0)}$ | $C_{3}^{(0)}$ | $C_{4}^{(0)}$ | $C_{5}^{(0)}$ | $C_{6}^{(0)}$ |
|---|---|---|---|---|---|---|---|---|---|---|---|
| -2/256 | 3/256 | 4/256 | -28/256 | 62/256 | 178/256 | 62/256 | -28/256 | 4/256 | 3/256 | -2/256 | 0/256 |

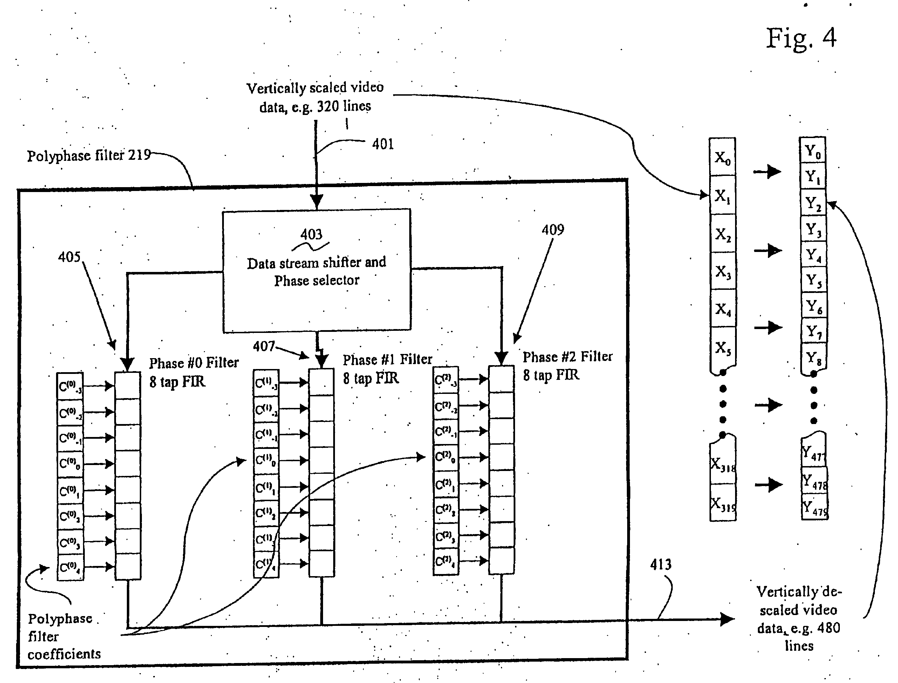

Fig. 4 is a block diagram detailing the structure of the polyphase filter 219 implemented in the vertical video data re-processor 217, in accordance with an embodiment of the present invention. The polyphase filter 219 increases the number of lines, e.g. 320, of the input video data stream 401 to a greater number of lines, e.g. 480, in the scaled output video data stream 413. The data stream shifter and phase selector 403 controls the phase paths 405, 407, and 409 and the input data center used to generate an output data point.

For each output $Y_n$ (n = 0, 1, 2, ...) the phase index P for the polyphase filter is derived by:

P = 2n % 3, where % means divide and take the remainder.

For each output $Y_n$ (n = 0, 1, 2, ...) the input data center $X_m$ must be selected for filtering. For the eight tap FIR filter paths 405, 407, and 409, the input data center is the 4$^{th}$ tap on the filters. For each output $Y_n$ (n = 0, 1, 2, ...) the input data center $X_m$ is derived by:

m = [2n/3], where [ ] means the integer part.

Therefore the following correspondences are achieved in vertical video data processing:

| | | | | | | | | | |
|---|---|---|---|---|---|---|---|---|---|
| Output pixels: | $Y_0$ | $Y_1$ | $Y_2$ | $Y_3$ | $Y_4$ | $Y_5$ | $Y_6$ | ... |
| Filter center pixels (input): | $X_0$ | $X_0$ | $X_1$ | $X_2$ | $X_2$ | $X_3$ | $X_4$ | ... |
| Phase: | 0 | 2 | 1 | 0 | 2 | 1 | 0 | ... |

To further illustrate the current example of upsampling, output pixel $Y_4$ is generated by Phase #2 filter path 409 according to the following formula:

$$Y_4 = \sum_{i=-3}^{4} C_i^{(2)} \bullet X_{2+i}$$

Where the values of coefficients of the phase #2 filter path 409 are:

| $C_{-3}^{(2)}$ | $C_{-2}^{(2)}$ | $C_{-1}^{(2)}$ | $C_{0}^{(2)}$ | $C_{1}^{(2)}$ | $C_{2}^{(2)}$ | $C_{3}^{(2)}$ | $C_{4}^{(2)}$ |
|---|---|---|---|---|---|---|---|
| -2/256 | 6/256 | -25/256 | 98/256 | 209/256 | -39/256 | 11/256 | -2/256 |

Continuing the up-sampling example, pixel $Y_5$ is generated by the Phase #1 filter path 407 according to the following formula:

$$Y_5 = \sum_{i=-3}^{4} C_i^{(1)} \bullet X_{3+i}$$

Where the values of coefficients of the phase #1 filter path 407 are:

| $C_{-3}^{(1)}$ | $C_{-2}^{(1)}$ | $C_{-1}^{(1)}$ | $C_{0}^{(1)}$ | $C_{1}^{(1)}$ | $C_{2}^{(1)}$ | $C_{3}^{(1)}$ | $C_{4}^{(1)}$ |
|---|---|---|---|---|---|---|---|
| -2/256 | 11/256 | -39/256 | 209/256 | 98/256 | -25/256 | 6/256 | -2/256 |

Continuing the up-sampling example, pixel $Y_6$ is generated by the Phase #0 filter path 405 according to the following formula:

$$Y_6 = \sum_{i=-3}^{4} C_i^{(0)} \bullet X_{4+i}$$

Where the values of coefficients of the phase #0 filter path 405 are:

$$C_{-3}^{(0)} \quad C_{-2}^{(0)} \quad C_{-1}^{(0)} \quad C_0^{(0)} \quad C_1^{(0)} \quad C_2^{(0)} \quad C_3^{(0)} \quad C_4^{(0)}$$

| $0$ | $0$ | $0$ | $1$ | $0$ | $0$ | $0$ | $0$ |

As mentioned above in the background section, the state of the art today involves compression of progressive content, whether intended for TV display or not, to a picture height that matches the frame height of the display. For NTSC-compatible systems, the picture height is 480 lines. For PAL and SECAM-compatible systems, the picture height is 576 lines. [Note that the exact total picture height of interlaced systems is usually specified with slightly larger numbers, such as 483.5 for NTSC, but the additional lines are not visible on a conventional TV, and the picture sizes to be compressed are generally chosen to be multiples of 16 for convenience for the compression methods.]

As demonstrated and explained above, such picture heights going into a compression system result in higher bit rates than are achieved with the present invention, when all other things are held equal (i.e., final picture quality and the type and quality of the compression and de-compression system). An alternative picture height is chosen for lower resolution and generally older systems, such as VCD. In such systems the picture height is generally chosen to be ½ that of the frame height of the display. For example, NTSC-compatible systems use a picture height of 240 lines, and PAL/SECAM-compatible systems use a picture height of 288 lines. Such picture heights are part of formats that are sometimes variously called SIF (standard image format) or CIF (common image format). CIF and SIF images produce visibly inferior quality to full picture height (e.g., 480 lines or 576 lines).

As an alternative, certain embodiments of the present invention may comprise only the compression side or de-compression side. For example, an embodiment of the present invention may comprise the vertical video data processor 203, video data compressor 207, and horizontal video data scaler 209. Other alternative embodiments of the present invention may comprise various combinations of the elements of Fig. 1 and Fig. 2.

In summary, certain embodiments of the present invention provide for low compressed bit rates, improved video quality, or both, compared with all known prior art, independently of any other methods that may be used for compression. The present invention may readily be combined with any compression method, whether old or new, and provides the claimed advantages in all known cases. The present invention is also easy to implement using methods for sample rate converter design and implementation, and has no known drawbacks other than the mere cost of implementation. Certain embodiments of the present invention may even be used with some existing MPEG-2 decoders in cases where such decoders or decoder systems include good quality vertical sample rate converters in the display path.

While the invention has been described with reference to certain embodiments, it will be understood by those skilled in the art that various changes may be made and equivalents may be substituted without departing from the scope of the invention. In addition, many modifications may be made to adapt a particular situation or material to the teachings of the invention without departing from its scope. Therefore, it is intended that the invention not be limited to the particular embodiment disclosed, but that the invention will include all embodiments falling within the scope of the appended claims.

**Claims**

1. A method for compressing and de-compressing video data, said method comprising:

   a) polyphase filtering a first number of vertical lines of said video data to generate a second number of vertical lines of said video data, wherein said polyphase filtering comprises using two phases of finite impulse response filters with twelve taps per phase;
   b) compressing said second number of vertical lines of said video data according to a standard compression technique;
   c) de-compressing said video data according to a standard de-compressing technique to generate said second number of vertical lines of said video data; and
   d) polyphase filtering said second number of vertical lines of said video data to generate a first number of vertical lines of said video data, wherein said polyphase filtering comprises using three phases of finite impulse response filters with eight taps per phase.

2. The method of claim 1, wherein said first number of vertical lines is greater than said second number of vertical lines.

3. The method of claim 1, wherein in step a) said polyphase filtering said first number of vertical lines of said video data to generate said second number of vertical lines of said video data comprises performing low-pass filtering with a cutoff frequency of about 0.67 a vertical Nyquist sample rate of said video data.

4. The method of claim 1, wherein said polyphase filtering in step a) and d) comprises performing sample rate conversion of said video data.

5. The method of claim 1, wherein said first number of lines of said video data comprises about 480 lines and wherein said second number of lines comprises about 320 lines.

6. The method of claim 1 further comprising performing horizontal video scaling of said video data to reduce a horizontal size of said video data from a first number of pixels to a second number of pixels before said compressing and further comprising performing horizontal video de-scaling of said video data to increase a horizontal size of said video data from said second number of pixels to said first number of pixels after said decompressing.

7. The method of claim 1 further comprising performing horizontal video scaling of said video data to reduce a horizontal size of said video data from about 720 pixels per vertical line to about 512 pixels per vertical line before said compressing and further comprising horizontal video de-scaling of said video data to increase a horizontal size of said vide data from about 512 pixels per vertical line to about 720 pixels per vertical line.

8. Apparatus for compressing and de-compressing video data, said apparatus comprising:

   a vertical video data processor that polyphase filters a number of vertical lines of said video data to generate a second number of vertical lines of said video data, wherein said vertical video data processor comprises two phases of finite impulse response filters with twelve taps per phase;
   a video data compressor that compresses said video data according to a standard compression technique after said vertical video data processor polyphase filters said first number of vertical lines of said video data to generate said second number of vertical lines of said video data;
   a video data de-compressor that decompresses said video data according to a standard de-compression technique to generate said second number of vertical lines of video data; and
   a vertical video data re-processor that polyphase filters said second number of vertical lines of said video data to generate a first number of vertical lines of said video data, wherein said vertical data re-processor comprises three phases of finite impulse response filters with eight taps per phase.

9. The apparatus of claim , wherein said vertical video data processor comprises a low pass filter with a cutoff frequency of about 0.67 of a vertical Nyquist sample rate of said video data.

10. The apparatus of claim 8, wherein said vertical video data processor comprises a sample rate converter for downsampling said first number of vertical lines to said second number of vertical lines and wherein said vertical video data re-processor comprises a sample rate converter for upsampling said second number of vertical lines to said first number of vertical lines.

11. The apparatus of claim 8, wherein said first number of vertical lines of said video data comprises about 480 lines and wherein said second number of lines of said video data comprises about 320 lines.

12. The apparatus of claim 8 further comprising a horizontal video data scaler that reduces a horizontal size of said video data from a first number of pixels to a second number of pixels before compressing and further comprising a horizontal video data de-scaler that increases a horizontal size of said video data from a second number of horizontal pixels to a first number of horizontal pixels.

13. The apparatus of claim 8 further comprising a horizontal video data scaler that reduces a horizontal size of said video data from about 720 pixels per vertical line to about 512 pixels per vertical line before compressing and further comprising a horizontal video data de-scaler that increases a horizontal size of said video data from about 512 pixels per vertical line to about 720 pixels per vertical line.

**Patentansprüche**

1. Verfahren zum Komprimieren und Dekomprimieren von Videodaten, wobei das Verfahren umfasst:

a) Mehrphasenfiltern einer ersten Anzahl von vertikalen Zeilen der Videodaten, um eine zweite Anzahl von vertikalen Zeilen der Videodaten zu erzeugen, wobei das Mehrphasenfiltern die Verwendung von zwei Phasen von FIR (*"finite impulse response"*)-Filtern mit zwölf Abgriffen pro Phase umfasst;

b) Komprimieren der zweiten Anzahl von vertikalen Zeilen der Videodaten gemäß einem standardmäßigen Komprimierungsverfahren;

c) Dekomprimieren der Videodaten gemäß einem standardmäßigen Dekomprimierungsverfahren, um die zweite Anzahl von vertikalen Zeilen der Videodaten zu erzeugen; und

d) Mehrphasenfiltern der zweiten Anzahl von vertikalen Zeilen der Videodaten zum Erzeugen einer ersten Anzahl von vertikalen Zeilen der Videodaten, wobei das Mehrphasenfiltern die Verwendung von drei Phasen von FIR-Filtern mit acht Abgriffen pro Phase umfasst.

2. Verfahren nach Anspruch 1, wobei die erste Anzahl von vertikalen Zeilen größer als die zweite Anzahl von vertikalen Zeilen ist.

3. Verfahren nach Anspruch 1, wobei in Schritt a) das Mehrphasenfiltern der ersten Anzahl von vertikalen Zeilen der Videodaten zum Erzeugen der zweiten Anzahl von vertikalen Zeilen der Videodaten die Durchführung eines Tiefpassfilterns mit einer Grenzfrequenz von etwa 0,67 einer vertikalen Nyquist-Abtastfrequenz der Videodaten umfasst.

4. Verfahren nach Anspruch 1, wobei das Mehrphasenfiltern in Schritt a) und d) das Durchführen einer Abtastfrequenz-Konversion der Videodaten umfasst.

5. Verfahren nach Anspruch 1, wobei die erste Anzahl von Zeilen der Videodaten etwa 480 Zeilen umfasst, und die zweite Anzahl von Zeilen etwa 320 Zeilen umfasst.

6. Verfahren nach Anspruch 1, welches ferner das Durchführen einer horizontalen Videoskalierung der Videodaten umfasst, um vor dem Komprimieren einen horizontalen Umfang der Videodaten von einer ersten Anzahl von Pixeln auf eine zweite Anzahl von Pixeln zu reduzieren, und welches ferner das Durchführen einer horizontalen Videodeskalierung der Videodaten umfasst, um einen horizontalen Umfang der Videodaten von der zweiten Anzahl von Pixeln auf die erste Anzahl von Pixeln zu vergrößern.

7. Verfahren nach Anspruch 1, welches ferner die Durchführung einer horizontalen Videoskalierung der Videodaten umfasst, um vor dem Komprimieren einen horizontalen Umfang der Videodaten von etwa 720 Pixeln pro vertikale Zeile auf etwa 512 Pixel pro vertikale Zeile zu verringern, und ferner die Durchführung einer horizontalen Videodeskalierung der Videodaten umfasst, um einen horizontalen Umfang der Videodaten von etwa 512 Pixeln pro vertikale Zeile auf etwa 720 Pixel pro vertikale Zeile zu vergrößern.

8. Vorrichtung zum Komprimieren und Dekomprimieren von Videodaten, wobei die Vorrichtung aufweist:

einen Vertikalvideodaten-Prozessor, der eine Anzahl von vertikalen Zeilen der Videodaten mehrphasenfiltert, um eine zweite Anzahl von vertikalen Zeilen der Videodaten zu erzeugen, wobei der Vertikalvideodaten-Prozessor zwei Phasen von FIR-Filtern mit zwölf Abgriffen pro Phase aufweist;

einen Videodaten-Komprimierer, der die Videodaten gemäß einem standardmäßigen Komprimierungsverfahren komprimiert, nachdem der Vertikalvideodaten-Prozessor die erste Anzahl von vertikalen Zeilen der Videodaten mehrphasenfiltert, um die zweite Anzahl von vertikalen Zeilen der Videodaten zu erzeugen;

einen Videodaten-Dekomprimierer, der die Videodaten gemäß einem standardmäßigen Dekomprimierungsverfahren dekomprimiert, um die zweite Anzahl von vertikalen Zeilen von Videodaten zu erzeugen; und

einen Vertikaldaten-Reprozessor, der die zweite Anzahl von vertikalen Zeilen der Videodaten mehrphasenfiltert, um eine erste Anzahl von vertikalen Zeilen der Videodaten zu erzeugen, wobei der Vertikaldaten-Reprozessor drei Phasen von FIR-Filtern mit acht Abgriffen pro Phase aufweist.

9. Vorrichtung nach Anspruch 8, wobei der Vertikalvideodaten-Prozessor ein Tiefpassfilter mit einer Grenzfrequenz von etwa 0,67 einer vertikalen Nyquist-Abtastfrequenz der Videodaten aufweist.

10. Vorrichtung nach Anspruch 8, wobei der Vertikalvideodaten-Prozessor einen Abtastfrequenz-Konverter zum Dezimieren (*"downsampling"*) der ersten Anzahl von vertikalen Zeilen auf die zweite Anzahl von vertikalen Zeilen aufweist, und wobei der Vertikalvideodaten-Reprozessor einen Abtastfrequenz-Konverter zum Expandieren (*"upsampling"*) der zweiten Anzahl von vertikalen Zeilen auf die erste Anzahl von vertikalen Zeilen aufweist.

**11.** Vorrichtung nach Anspruch 8, wobei die erste Anzahl von vertikalen Zeilen der Videodaten etwa 480 Zeilen umfasst, und wobei die zweite Anzahl von Zeilen der Videodaten etwa 320 Zeilen umfasst.

**12.** Vorrichtung nach Anspruch 8, welche ferner einen Horizontalvideodaten-Skalierer aufweist, der vor dem Komprimieren einen horizontalen Umfang der Videodaten von einer ersten Anzahl von Pixeln auf eine zweite Anzahl von Pixeln reduziert, und ferner einen Horizontalvideodaten-Deskalierer aufweist, der einen horizontalen Umfang der Videodaten von einer zweiten Anzahl von horizontalen Pixeln auf eine erste Anzahl von horizontalen Pixeln erhöht.

**13.** Vorrichtung nach Anspruch 8, welche ferner einen Horizontalvideodaten-Skalierer aufweist, der vor dem Komprimieren einen horizontalen Umfang der Videodaten von etwa 720 Pixeln pro vertikale Zeile auf etwa 512 Pixel pro vertikale Zeile reduziert, und ferner einen Horizontalvideodaten-Deskalierer aufweist, der einen horizontalen Umfang der Videodaten von etwa 512 Pixeln pro vertikale Zeile auf etwa 720 Pixel pro vertikale Zeile erhöht.

**Revendications**

**1.** Procédé pour la compression et la décompression de données vidéo, ledit procédé comprenant :

a) un filtrage polyphasé d'un premier nombre de lignes verticales desdites données vidéo pour générer un deuxième nombre de lignes verticales desdites données vidéo, dans lequel ledit filtrage polyphasé comprend l'utilisation de deux phases de filtres à réponse impulsionnelle finie avec douze prises par phase ;
b) une compression dudit deuxième nombre de lignes verticales desdites données vidéo selon une technique de compression standard ;
c) une décompression desdites données vidéo selon une technique de décompression standard pour générer ledit deuxième nombre de lignes verticales desdites données vidéo ; et
d) un filtrage polyphasé dudit deuxième nombre de lignes verticales desdites données vidéo pour générer un premier nombre de lignes verticales desdites données vidéo, dans lequel ledit filtrage polyphasé comprend l'utilisation de trois phases de filtres à réponse impulsionnelle finie avec huit prises par phase.

**2.** Procédé selon la revendication 1, dans lequel ledit premier nombre de lignes verticales est supérieur audit deuxième nombre de lignes verticales.

**3.** Procédé selon la revendication 1, dans lequel dans l'étape a) ledit filtrage polyphasé dudit premier nombre de lignes verticales desdites données vidéo pour générer ledit deuxième nombre de lignes verticales desdites données vidéo comprend un filtrage passe-bas avec une fréquence de coupure d'environ 0,67 d'un taux d'échantillonnage de Nyquist vertical desdites données vidéo.

**4.** Procédé selon la revendication 1, dans lequel ledit filtrage polyphasé dans l'étape a) et d) comprend une conversion de taux d'échantillonnage desdites données vidéo.

**5.** Procédé selon la revendication 1, dans lequel ledit premier nombre de lignes desdites données vidéo comprend environ 480 lignes et dans lequel ledit deuxième nombre de lignes desdites données vidéo comprend environ 320 lignes.

**6.** Procédé selon la revendication 1 comprenant en outre le fait d'effectuer un cadrage vidéo horizontal desdites données vidéo pour réduire une dimension horizontale desdites données vidéo d'un premier nombre de pixels à un deuxième nombre de pixels avant ladite compression et comprenant en outre le fait d'effectuer un décadrage vidéo horizontal desdites données vidéo pour augmenter une dimension horizontale desdites données vidéo dudit deuxième nombre de pixels audit premier nombre de pixels avant ladite décompression.

**7.** Procédé selon la revendication 1 comprenant en outre le fait d'effectuer un cadrage vidéo horizontal desdites données vidéo pour réduire une dimension horizontale desdites données vidéo d'environ 720 pixels par ligne verticale à environ 512 pixels par ligne verticale avant ladite compression et comprenant en outre le fait d'effectuer un décadrage vidéo horizontal desdites données vidéo pour augmenter une dimension horizontale desdites données vidéo d'environ 512 pixels par ligne verticale à environ 720 pixels par ligne verticale.

**8.** Dispositif pour la compression et la décompression de données vidéo, ledit dispositif comprenant :

un processeur de données vidéo verticales qui filtre en polyphasé un premier nombre de lignes verticales desdites données vidéo pour générer un deuxième nombre de lignes verticales desdites données vidéo, dans lequel ledit filtrage polyphasé comprend deux phases de filtres à réponse impulsionnelle finie avec douze prises par phase ;

un compresseur de données vidéo qui comprime lesdites données vidéo selon une technique de compression standard après que ledit processeur de données vidéo verticales filtre en polyphasé ledit premier nombre de lignes verticales desdites données vidéo pour générer ledit deuxième nombre de lignes verticales desdites données vidéo ;

un décompresseur de données vidéo qui décomprime lesdites données vidéo selon une technique de décompression standard pour générer ledit deuxième nombre de lignes verticales desdites données vidéo ; et

un re-processeur de données vidéo verticales qui filtre en polyphasé ledit deuxième nombre de lignes verticales desdites données vidéo pour générer un premier nombre de lignes verticales desdites données vidéo, dans lequel ledit filtrage polyphasé comprend trois phases de filtres à réponse impulsionnelle finie avec huit prises par phase.

9. Dispositif selon la revendication 8, dans lequel ledit processeur de données vidéo verticales comprend un filtre passe-bas avec une fréquence de coupure d'environ 0,67 d'un taux d'échantillonnage de Nyquist vertical desdites données vidéo.

10. Dispositif selon la revendication 8, dans lequel ledit processeur de données vidéo verticales comprend un convertisseur de taux d'échantillonnage pour échantillonner vers le bas ledit premier nombre de lignes verticales audit deuxième nombre de lignes verticales et dans lequel ledit re-processeur de données vidéo verticales comprend un convertisseur de taux d'échantillonnage pour échantillonner vers le haut ledit deuxième nombre de lignes verticales audit premier nombre de lignes verticales.

11. Dispositif selon la revendication 8, dans lequel ledit premier nombre de lignes desdites données vidéo comprend environ 480 lignes et dans lequel ledit deuxième nombre de lignes desdites données vidéo comprend environ 320 lignes.

12. Dispositif selon la revendication 8 comprenant en outre un dispositif de cadrage de données vidéo horizontal qui réduit une dimension horizontale desdites données vidéo d'un premier nombre de pixels à un deuxième nombre de pixels avant la compression et comprenant en outre un dispositif de décadrage de données vidéo horizontal qui augmente une dimension horizontale desdites données vidéo d'un deuxième nombre de pixels horizontaux à un premier nombre de pixels horizontaux.

13. Dispositif selon la revendication 8 comprenant en outre un dispositif de cadrage de données vidéo horizontal qui réduit une dimension horizontale desdites données vidéo d'environ 720 pixels par ligne verticale à environ 512 pixels par ligne verticale avant la compression et comprenant en outre un dispositif de décadrage de données vidéo horizontal qui augmente une dimension horizontale desdites données vidéo d'environ 512 pixels par ligne verticale à environ 720 pixels par ligne verticale.

## Fig. 1

100

101 — Input uncompressed progressive video data, e.g. 720 x 480

103 — Perform Polyphase filtering comprising low-pass filtering & sample rate conversion

105 — Pass Vertically scaled video data e.g. 720 x 320

107 — Perform Video compression process

109 — Perform Transmission or Storage

111 — Perform Video decompression process

113 — Pass Vertically scaled video data e.g. 720 x 320

115 — Perform Polyphase filtering comprising sample rate conversion

117 — Output Uncompressed progressive video data, e.g. 720 x 480

Fig. 2

Fig. 3

Y₀ Y₁ Y₂ Y₃ Y₄ Y₅ . . . . Y₃₁₈ Y₃₁₉

X₀ X₁ X₂ X₃ X₄ X₅ X₆ X₇ X₈ . . . . X₄₇₇ X₄₇₈ X₄₇₉

Vertically scaled video data, e.g. 320 lines (Y₀, Y₁, . . . Y₃₁₉)

311

Polyphase filter 205

Vertically unscaled video data, e.g. 480 lines (X₀, X₁, . . . X₄₇₉)

301

303
Data stream shifter and Phase selector

307

Phase #1 Filter 12 tap FIR

C⁽¹⁾₋₅ C⁽¹⁾₋₄ C⁽¹⁾₋₃ C⁽¹⁾₋₂ C⁽¹⁾₋₁ C⁽¹⁾₀ C⁽¹⁾₁ C⁽¹⁾₂ C⁽¹⁾₃ C⁽¹⁾₄ C⁽¹⁾₅ C⁽¹⁾₆

305

Phase #0 Filter 12 tap FIR

C⁽⁰⁾₋₅ C⁽⁰⁾₋₄ C⁽⁰⁾₋₃ C⁽⁰⁾₋₂ C⁽⁰⁾₋₁ C⁽⁰⁾₀ C⁽⁰⁾₁ C⁽⁰⁾₂ C⁽⁰⁾₃ C⁽⁰⁾₄ C⁽⁰⁾₅ C⁽⁰⁾₆

Polyphase filter coefficients

Fig. 4

EP 1 322 114 B1